Europäisches Patentamt

European Patent Office

Office européen des brevets

(11) Veröffentlichungsnummer: **0 186 865**
**B1**

(12) **EUROPÄISCHE PATENTSCHRIFT**

(45) Veröffentlichungstag der Patentschrift: **26.09.90**

(21) Anmeldenummer: **85116262.8**

(22) Anmeldetag: **19.12.85**

(51) Int. Cl.⁵: **H 01 J 37/32, H 03 K 3/57**

(54) Vorrichtung zur Unterbrechung von bogenförmigen Entladungen in einem Gasentladungsgefäss.

(30) Priorität: **29.12.84 BG 68215/84**

(43) Veröffentlichungstag der Anmeldung:
**09.07.86 Patentblatt 86/28**

(45) Bekanntmachung des Hinweises auf die
Patenterteilung:
**26.09.90 Patentblatt 90/39**

(84) Benannte Vertragsstaaten:
**CH DE FR GB LI SE**

(56) Entgegenhaltungen:
**BG-A- 22 590**
**FR-A-2 297 927**
**GB-A-2 045 553**

(73) Patentinhaber: **V M E I "LENIN"**
**Quartal Darvenitza**
**BG-1156 Sofia (BG)**

(72) Erfinder: **Mintchev, Mintcho Savov**
**100 Boul. Bulgaria**
**Sofia (BG)**
Erfinder: **Savov, Svetoslav Alexandrov**
**Block 90, Komplex Mladost**
**Sofia (BG)**
Erfinder: **Krestev, Emil Iliev**
**42, Kaymak Tchalan Str.**
**Sofia (BG)**

(74) Vertreter: **Ebbinghaus, Dieter et al**
**v. FÜNER, EBBINGHAUS, FINCK Patentanwälte**
**European Patent Attorneys Mariahilfplatz 2 & 3**
**D-8000 München 90 (DE)**

Courier Press, Leamington Spa, England.

**Beschreibung**

Die Erfindung betrifft eine Vorrichtung zur Unterbrechung von bogenförmigen Entladungen in einem Gasentladungsgefäß, das zur Oberflächenbearbeitung von Einzelteilen im Maschinenbau dient.

Es ist eine Vorrichtung zur Unterbrechung von bogenförmigen Entladungen in einem Gasentladungsgefäß bekannt, die aus einem Stromgleichrichter besteht, zu dem über eine Drossel das Gasentladungsgefäß und eine aus der Primärwicklung eines Sättigungstransformators und einem Kondensator bestehende Reihenschaltung parallelgeschaltet sind. An den Zwischenanschluß der Primärwicklung des Sättigungstransformators und den positiven Pol des Stromgleichrichters ist ein Thyristor angeschlossen, dessen Kathode mit dem Zwischenanschluß verbunden ist. Der Eingang eines ersten Steuerimpulsgenerators ist mit der Sekundärwicklung des Sättigungstransformators verbunden, und die zwei Ausgänge des ersten Steuerimpuls generators sind mit den zwei Ausgängen eines autonomen zweiten Steuerimpulsgenerators und mit der Steuerelektrode bzw. der Kathode des Thyristors verbunden (BG—PS 22 590).

Nachteil dieser Vorrichtung ist ihre ungenügende Effektivität, weil die Zeit vom Zeitpunkt der Ausschaltung des Thyristors bis zum Zeitpunkt der Erregung der Glimmentladung einen wechselnden Wert aufweist und von der Größe des Entladungsstromes abhängt, wobei kleinen Größen des Entladungsstromes große Werte dieser Zeit entsprechen und umgekehrt.

Der Erfingung liegt die Aufgabe zugrunde, eine Vorrichtung zur Unterbrechung bogenförmiger Entladungen in einem Gasentladungsgefäß zur Durchführung technologischer Prozesse zu schaffen, die bei der Anwendung sowohl mit niedrigen als auch mit nahe beim Nominalwert liegenden Werten des durch Gasentladungsgefäß fließenden Stromes die gleiche Effektivität aufweist.

Diese Aufgabe wird mittels einer Vorrichtung zur Unterbrechung von bogenförmigen Entladungen in einem Gasentladungsgefäß gelöst, die aus einem Stromgleichrichter besteht, zu dem über eine erste Drossel das Gasentladungsgefäß, ein Spannungsgeber und eine aus der Primärwicklung eines Sättigungstransformators und einem Kondensator bestehende Reihenschaltung parallelgeschaltet sind. Zu dem Zwischenanschluß der Primärwicklung des Sättigungstransformators und dem positiven Pol des Stromgleichrichters sind ein Thyristor und eine aus einer zweiten Drossel und einer Diode bestehende Reihenschaltung parallel geschaltet, wobei die Kathode des Thyristors und die Anode der Diode mit dem Zwischenanschluß verbunden sind. Der Eingang des ersten Steuerimpulsgenerators ist mit der Sekundärwicklung des Sättigungstransformators verbunden. Die zwei Ausgänge eines Spannungsgebers sind mit den zwei Eingängen eines autonomen zweiten Steuerimpulsgenerators verbunden, dessen zwei Ausgänge mit der Steuerelektrode bzw. der Kathode des Thyristors und mit den zwei Ausgängen des ersten Steuerimpulsgenerators verbunden sind.

Die Vorteile der erfindungsgemäßen Vorrichtung zur Unterbrechung von bogenförmigen Entladungen in einem Gasentladungsgefäß zur Durchführung technologischer Prozesse sind erstens die erhöhte Effektivität ihrer Anwendung, weil die Zeit vom Zeitpunkt der Ausschaltung des Thyristors bis zum Zeitpunkt der Erregung der Glimmentladung konstant ist und nicht von der Größe des Entladungsstromes abhängt, und zweitens der Schutz gegen Überspannungen im Gasentladungsgefäß.

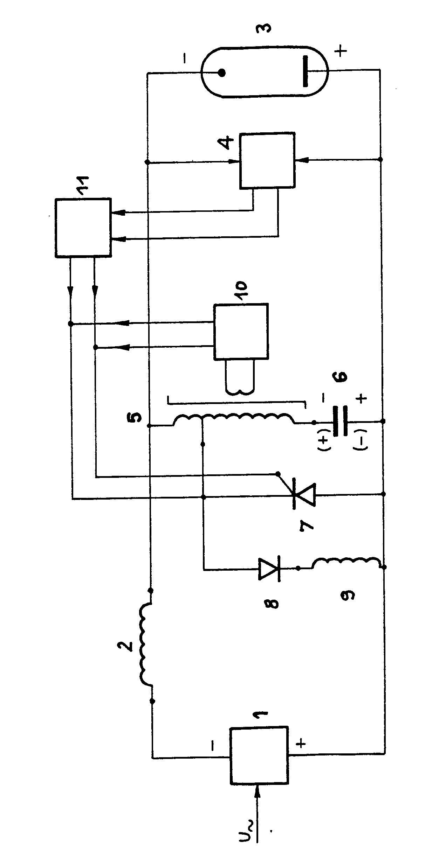

Ein Schaltbild eines Ausführungsbeispiels der erfindungsgemäßen Vorrichtung zur Unterbrechung von bogenförmigen Entladungen in einem Gasentladungsgefäß zur Durchführung technologischer Prozesse ist in der beigefügten Figur gezeigt.

Die Vorrichtung zur Unterbrechung bogenförmiger Entladungen in einem Gasentladungsgefäß enthält einem Stromgleichrichter 1, zu dem über eine erste Drossel 2 eine Gasentladungsgefäß 3, ein Spannungsgeber 4 und eine aus der Primärwicklung eines Sättigungstransformators 5 und einem Kondensator 6 bestehende Reihenschaltung parallelgeschaltet sind. Dem Zwischenanschluß der Primärwicklung des Sättigungstransformators 5 und dem positiven Pol des Stromgleichrichters 1 sind der Thyristor 7 und eine aus einer Diode 8 und einer zweiten Drossel 9 bestehende Reihenschaltung parallelgeschaltet, wobei die Kathode des Thyristors 7 und die Anode der Diode 8 mit dem Zwischenanschluß verbunden sind. Der Eingang eines ersten Steuerimpulsgenerators 10 ist mit der Sekundärwicklung des Sättigungstransformators 5 verbunden. Die zwei Ausgänge des Spannungsgebers 4 sind mit den zwei Eingängen eines autonom arbeitenden zweiten Steuerimpulsgenerators 11, verbunden, dessen zwei Ausgänge mit der Steuerelektrode bzw. der Kathode des Thyristors 7 und mit den zwei Ausgängen des ersten Steuerimpulsgenerators 10 verbunden sind.

Die Vorrichtung zur Unterbrechung bogenförmiger Entladungen in einem Gasentladungsgefäß zur Durchführung technologischer Prozesse funktioniert auf folgende Weise: Unter Einwirkung des Stromgleichrichters 1 entsteht eine elektrische Glimmentladung im Gasentladungsgefäß 3. Der Kondensator 6 beginnt sich aufzuladen, wobei der Magnetkern des Sättigungstransformators 5 für die Zeit der Aufladung des Kondensators 6 bis zum negativen Wert der Sättigungsinduktion gesättigt wird. Wenn die elektrische Glimmentladung im Gasentladungsgefäß 3 in eine bogenförmige Entladung übergeht, beginnt die Spannung zwischen Anode und Kathode des Gasentladungsgefäßes 3 zu sinken und an der Primärwicklung des Sättigungstransformators 5 entsteht eine Spannung, die der des Kondensators 6 und der Spannung zwischen Anode und Kathode des Gasentladungsgefäßes 3 gleich ist. Die in Sekundärwicklung des Sättigungstransformators 5 induzierte Spannung wird dem ersten Steuerimpulsgenerator 10 zugeführt und dieser schaltet den Thyristor 7 ein. In der Zeit, während der Thyristor 7 eingeschaltet ist, wird der über den Thyristor 7 fließende Strom von der Drossel 2 begrenzt. Die Spannung des Kondensators 6 wird über den eingeschalteten Thyristor 7 dem entsprechenden Teil der Primärwicklung des Sättigungstransformators 5 zugeführt. Dann wird auf die Anode und Kathode des Gasentladungsgefäßes 3 eine entgegengesetzte Spannung zugeführt, die vom Verhältnis zwischen den Wicklungen der beiden Teile der Primärwicklung des Sättigungstransformators 5 bestimmt wird. Diese entgegengesetzte Spannung verursacht für eine bestimmte Zeit einen Richtungswechsel des elektrischen Feldes im Gasentladungsgefäß 3, was den Deionisationsprozeß zwischen Anode und Kathode des Gasentladungsgefäßes unterstützt. Über den Thyristor 7 fließt der Entladungsstrom des Kondensators 6 und der Strom vom Stromgleichrichter 1 über den Teil (zur Kathode des Gasentladungsgefäßes 3) der Primärwicklung des Sättigungstransformators 5 und über die Drossel 2, wobei der Magnetkern des Sättigungstransformators 5 von einem negativen Wert der Sättigungsinduktion auf ihren positiven Wert ummagnetisiert wird. Der Teil der mit dem Kondensator 6 verbundenen Primärwicklung mit der Induktivität im Sättigungszustand ihres Magnetkerns und der Kondensator 6 bilden einen Schwingungskreis, in dem der Kondensator 6 bis zu einer Spannung mit engegengesetzter Polarität der Ausgangspolarität umgeladen wird, die in der Figur in Klammern gezeigt ist. Unter Einwirkung dieser Spannung beginnt sich der Magnetkern des Sättigungstransformators von einem positiven Wert der Sättigungsinduktion auf ihren negativen Wert umzumagnetisieren. Der Teil der mit dem Kondensator 6 verbundenen Primärwicklung mit Induktivität im Sättigungszustand ihres Magnetkerns und der Kondensator 6 bilden erneut einen Schwingungskreis, in dem der Kondensator 6 sich umzuladen beginnt. Der Umladestrom des Kondensators 6 fließt über den Thyristor 7 in entgegengesetzter Richtung seiner Druchlaßrichtung. Sobald dieser Strom den Wert des Thyristorstromes erreicht und überschreitet, schaltet der Thyristor 7 aus. Weiterhin verläuft der Umladeprozeß mit einer beständigen Dauer, die nicht vom Wert des Entladungsstromes über das Gasentladungsgefäß 3 anhängt und von den Parametern des Schwingungskreises bestimmt wird, der aus dem Kondensator 6, dem mit dem Kondensator 6 mit der Induktivität im Sättigungszustand des Magnetkerns und des Kondensators 6 verbundenen Teil der Primärwicklung des Transformators 5, der Diode 8 und der zweiten Drossel 9 besteht. Nachdem der zweite Umladeprozeß abgeschlossen ist, steigt die Spannung mit einer Polarität weiter, die mit der Ausgangspolarität gleich ist, und zwar unter Einwirkung des Stromes, der vom Stromgleichrichter 1 über den Kondensator 6, die Primärwicklung des Transformators 5 und über die erste Drossel 2 fließt. Der Spannungsanstieg hört auf, nachdem die Erregung der Glimmentladung im Gasentladungsgefäß erreicht wird. Bei Überschreitung des vorgegebenen Wertes der Spannung zwischen der Anode und der Kathode des Gasentladungsgefäßes 3, die mit dem Spannungs-Geber 4 gemessen wird, schaltet der autonome zweite Steuerimpulsgenerator 11 den Thyristor 7 ein, wonach in der Einrichtung Prozesse verlaufen, die gleich denen sind, wenn die Glimmentladung spontan in eine bogenförmige Entladung übergeht, womit das Gasentladungsgefäß 3 vor Spannungen mit einem größeren Wert als dem bestimmten Nominalwert geschützt wird. Bei einem zweiten Übergang der Glimmentladung in eine bogenförmige Entladung und bei einer zweiten Überschreitung des vorgegebenen Wertes der Spannung zwischen der Anode und der Kathode des Gasentladungsgefäßes 3 wiederholt sich die Funktionswirkung der Vorrichtung.

**Patentanspruch**

Vorrichtung zur Unterbrechung von bogenförmigen Entladungen in einem Gasentladungsgefäß (3) mit einem Stromgleichrichter (1), zu dem über eine erste Drossel (2) das Gasentladungsgefäß (3) und eine aus der Primärwicklung eines Sättigungstransformators (5) und einem Kondensator (6) bestehende Reihenschaltung parallelgeschaltet sind, wobei zwischen dem Zwischenanschluß der Primärwicklung des Sättigungstransformators (5) und dem positiven Pol des Stromgleichrichters (1) ein Thyristor (7) geschaltet ist, dessen Kathode mit dem Zwischenanschluß verbunden ist, wobei die beiden Eingänge eines ersten Steuerimpulsgenerators (10) mit den beiden Anschlüssen der Sekundärwicklung des Sättigungstransformators (5) verbunden sind und die beiden Ausgänge des ersten Steuerimpulsgenerators (10) jeweils mit einem der zwei Ausgänge eines autonomen zweiten Steuerimpulsgenerators (11) und mit der Steuerelektrode bzw. der Kathode des Thyristors (7) verbunden sind, dadurch gekennzeichnet, daß parallel zum Gasentladungsgefäß (3) die beiden Eingänge eines Spannungsgebers (4) geschaltet sind, dessen zwei Ausgänge jeweils mit einem der zwei Eingänge des autonomen zweiten Steuerimpulsgenerators (11) verbunden sind, und daß zwischen den Zwischenanschluß der Primärwicklung des Sättigungstransformators (5) und den positiven Anschluß des Stromgleichrichters (1) eine aus einer Diode (8) und einer zweiten Drossel (9) bestehende Reihenschaltung geschaltet ist, wobei die Anode der Diode (8) mit dem Zwischenanschluß verbunden ist.

**Revendication**

Dispositif de coupure de décharges en arc dans une enceinte à décharge dans un gaz (3) comportant un redresseur de courant (1) sur lequel sont connectés en parallèle, par l'intermédiaire d'une première bobine d'induction (2), l'enceinte à décharge dans un gaz (3) et un circuit série formé de l'enroulement primaire d'un transformateur de saturation (5) et d'un condensateur (6), moyennant quoi, entre la borne intermédiaire de l'enroulement primaire du transformateur de saturation (5) et le pôle positif du redresseur de courant (1), est raccordé un thyristor (7) dont la cathode est reliée à la borne intermédiaire, les deux entrées d'un premier générateur d'impulsions de commande (10) étant reliées aux deux bornes de l'enroulement secondaire du transformateur de saturation (5) et les deux sorties du premier générateur d'impulsions de commande (10) étant reliées chacune à l'une des deux sorties d'un second générateur d'impulsions de commande autonome (11) et à l'électrode de commande, respectivement à la cathode du thyristor (7), caractérisé en ce que, en parallèle sur l'enceinte à décharge dans un gaz (3), sont connectées les deux entrées d'un indicateur de tension (4) dont les deux sorties sont reliées chacune à l'une des deux entrées du second générateur d'impulsions de commande autonome (11), et en ce que, entre la borne intermédiaire de l'enroulement primaire du transformateur de saturation (5) et la borne positive du redresseur de courant (1), est connecté un circuit série formé d'une diode (8) et d'une seconde bobine d'induction (9), l'anode de la diode (8) étant reliée à ladite borne intermédiaire.

**Claim**

A device for interrupting arc discharges in a gas discharge vessel (3) with a current rectifier (1) to which the gas discharge vessel (3) and a series connection consisting of the primary winding of a saturation transformer (5) and a condenser (6) are connected in parallel by way of a first choke (2), wherein connected between the intermediary terminal of the primary winding of the saturation transformer (5) and the positive pole of the current rectifier (1) there is a thyristor (7), the cathode of which is connected to the intermediary terminal, wherein both inputs of a first control pulse generator (10) are connected to both connections of the secondary winding of the saturation transformer (5) and both outputs of the first control pulse generator (10) are in each case connected to one of the two outputs of an autonomous second control pulse generator (11) and to the control electrode and the cathode respectively of the thyristor (7), characterised in that both inputs of a voltage sensor (4) are connected parallel to the gas discharge vessel (3), the two outputs of which sensor (4) are in each case connected to one of the two inputs of the autonomous second control pulse generator (11), and in that between the intermediary terminal of the primary winding of the saturation transformer (5) and the positive connection of the current rectifier (1) a series connection consisting of a diode (8) and a second choke (9) is connected wherein the anode of the diode (8) is connected to the intermediary terminal.